# EUROPÄISCHE PATENTANMELDUNG

(11) **EP 4 230 765 A1**
(43) Veröffentlichungstag der Anmeldung: **23.08.2023**
(21) Anmeldenummer: 22157496.5
(22) Anmeldetag: 18.02.2022
(51) Int. Cl.: C23C 16/48, C23C 16/04, H01J 37/32, C23C 16/26

(54) **VERFAHREN UND VORRICHTUNG ZUR CHEMISCHEN GASPHASENABSCHEIDUNG**

(71) Anmelder: Justus-Liebig-Universität Gießen, 35390 Gießen (DE)
(72) Erfinder: Chatterjee, Sangam, 35392 Gießen (DE); Klar, Peter, 35392 Gießen (DE); Von Roeder, Maximilian, 35630 Ehringshausen (DE); Groß, Hartmut, 35452 Heuchelheim (DE); Schneweis, Stefan, 35452 Heuchelheim (DE)
(74) Vertreter: Stumpf, Peter

(57) **Zusammenfassung**

Die Erfindung betrifft ein Verfahren zur chemischen Gasphasenabscheidung umfassend wenigstens die folgenden Schritte
I. Einbringen eines zu beschichtenden Substrates (30) und mindestens einer gasförmigen Vorläuferverbindung (20) in ein Reaktionsgefäß (10), sodass eine Atmosphäre mit mindestens einer Vorläuferverbindung (20) im Reaktionsgefäß (10) gebildet wird.
II. Erhitzen der in Schritt I gebildeten Atmosphäre über wenigstens einem Abschnitt der Oberfläche des Substrates (30) mittels eines Lasers (50), sodass aus Atmosphäre ein Plasma erzeugt und aufrechterhalten wird, wodurch die mindestens eine Vorläuferverbindung (20) aufgespalten wird, sodass sich einzelne Atome, Moleküle oder Ionen bilden und dadurch für die Beschichtungsreaktion aktiviert werden.
III. Reaktion der in Schritt II erzeugten Moleküle, Atome oder Ionen mit dem zu beschichtenden Substrat (30) oder in dessen Nähe und Erzeugung einer Beschichtung auf der Oberfläche des Substrates (30).

## Beschreibung

Die Erfindung betrifft ein Verfahren und eine Vorrichtung zur chemischen Gasphasenabscheidung zur Beschichtung von Werkstücken.

### Beschreibung und Einleitung des allgemeinen Gebietes der Erfindung

Ein für die Beschichtung von Oberflächen sehr wichtiges Verfahren ist die chemische Gasphasenabscheidung (engl. CVD chemical vapor deposition). Dabei wird an der Oberfläche eines Substrates aufgrund einer chemischen Reaktion aus der Gasphase eine Feststoffkomponente abgeschieden. Voraussetzung hierfür ist, dass flüchtige und reaktive Verbindungen in der Gasphase existieren, die unter bestimmten Reaktionsbedingungen eine feste Schicht abscheiden.

Das Verfahren der chemischen Gasphasenabscheidung zeichnet sich durch mindestens eine chemische Reaktion an der Oberfläche oder in der Nähe der Oberfläche des zu beschichtenden Werkstücks aus. An dieser Reaktion müssen mindestens ein gasförmiges Edukt und mindestens zwei Reaktionsprodukte - davon mindestens eines in der festen Phase - beteiligt sein. Um gegenüber konkurrierenden Gasphasen-Reaktionen jene gewünschten Reaktionen an der Oberfläche oder in Oberflächennähe zu fördern und damit die Bildung von festen Partikeln in der Gasphase zu vermeiden, werden Prozesse chemischer Gasphasenabscheidung zumeist bei reduziertem Druck betrieben (typisch: 1-1000 Pa).

Eine besondere Eigenschaft des Verfahrens in seiner Ausbildung als Einzelatomlagen-Deposition ist die konforme Schichtabscheidung. Im Unterschied zu physikalischen Verfahren ermöglicht die chemische Gasphasenabscheidung auch die Beschichtung von komplex dreidimensional geformten Oberflächen. So können z. B. feinste Vertiefungen in Wafern oder auch Hohlkörper auf ihrer Innenseite gleichmäßig beschichtet werden.

### Stand der Technik

Übliche Verfahren zur chemischen Gasphasenabscheidung basieren zumeist darauf, dass an einer erhitzten Oberfläche eines Substrates aufgrund einer chemischen Reaktion aus der Gasphase eine Feststoffkomponente abgeschieden wird. Das Erhitzen erfolgt üblicherweise in einem Ofen. In diesen ofengestützten Prozessen können durch den Einsatz molekularer Vorläufersubstanzen im Temperaturgradienten vor und hinter der heißen Zone (oftmals >500°C) unerwünschte Nebenreaktionen auftreten, welche möglicherweise zur Untauglichkeit eines Werkstücks bei kontinuierlicher Verarbeitung führen. Ofenanlagen haben den oben genannten Nachteil der unerwünschten Nebenreaktionen in den räumlich ausgedehnten Zonen des Temperaturgradienten von Prozess- (oftmals >500°C) zu Raumtemperatur (ca. 20°C). Außerdem sind die Betriebskosten hoch. Solche Ofenanlagen sind nur mit vergleichsweise hohen Sicherheitsrisiken und Wartungskosten zu betreiben. Eine weitere Einschränkung des Verfahrens stellt die hohe Temperaturbelastung des Substrates dar. Die Wärmebelastung kann unter anderem Verzug an Werkstücken bedingen oder oberhalb der Erweichungstemperatur des zu beschichtenden Materials liegen, sodass das Verfahren nicht angewendet werden kann. Außerdem kommt es bei hohen Temperaturen zu Diffusionsprozessen, dadurch werden Dotierprofile im abgeschiedenen Material verschmiert oder Fremdatome diffundieren im Beschichtungsprozess in das Werkstück ein.

Alternativ gibt es lasergestützte chemische Gasphasenabscheidungsprozesse, bei denen der Laser nur zum Heizen des Substrats eingesetzt wird. Diese bergen den Vorteil, dass die benötigte Temperatur auf eine kleine Fläche lokalisiert werden kann und Temperaturgradienten sehr klein sind.

Sowohl das ofengestützte Verfahren als auch das lasergestützte Verfahren nutzen temperaturgetriebene Reaktionen zur Beschichtung der Oberflächen. Diese sind in der Wahl der Vorläuferverbindungen eingeschränkt (z.B. müssen bei der Beschichtung von SiC mit BN Borane oder Halogenide als Vorläuferverbindungen genutzt werden). Diese Vorläuferverbindungen bergen teilweise sehr hohe Sicherheitsrisiken (z.B. Borane bilden explosive Gemische an Luft, bei der Verwendung von BF₃ oder BBr₃ entsteht Flusssäure bzw. Brom Wasserstoff) und können den Wartungsaufwand der Anlage enorm erhöhen (z.B. Nebelbildung bei Verwendung von Borhalogeniden und NH₃/H₂). Ein aktuelles Beispiel ist die kontinuierliche Beschichtung von SiC-Faserbündeln mit BN, dessen gewünschte hexagonale Modifikation nur bei höheren Temperaturen (>1500 °C) entsteht. Im konventionellen thermischen Beschichtungsprozess ist man in der Wahl der Vorläuferverbindungen limitiert. Außerdem sind die Energiekosten für den Betrieb einer thermischen Beschichtungsanlage sehr hoch, machen also einen Großteil der Prozesskosten aus und können wesentlich zu den Herstellungskosten des beschichteten Werkstücks beitragen.

Durch die plasmaunterstützte chemische Gasphasenabscheidung (engl.: plasma enhanced CVD, PECVD) kann die Temperaturbelastung des Substrates reduziert werden. Dabei wird oberhalb des Wafers ein Plasma gezündet. Dies kann entweder induktiv (engl.: inductively-coupled PECVD, ICPECVD) oder kapazitiv (engl.: capacitance-coupled PECVD) geschehen. Dieses CVD-Verfahren findet bei Temperaturen zwischen 200 und 500 °C statt. Allerdings besteht hierbei der Nachteil, dass durch schnelle Teilchen aus dem Plasma die Morphologie des Substrats verändert wird. Ein weiterer Nachteil ist, dass nicht alle Ausbildungsformen der PECVD bei nichtleitenden Substraten oder für kontinuierliche Beschichtungsprozesse eingesetzt werden können.

### Aufgabe

Aufgabe der vorliegenden Erfindung ist es, ein Verfahren zur kontinuierlichen und energieeffizienten chemischen Gasphasenabscheidung insbesondere für eine lokale Beschichtung von Substraten bereitzustellen.

### Lösung der Aufgabe

Die Aufgabe wird durch das Verfahren mit den Merkmalen des Hauptanspruchs gelöst. Vorteilhafte Weiterbildungen der Erfindung sind in den Unteransprüchen beschrieben.

Das erfindungsgemäße Verfahren zur Beschichtung eines Substrats umfasst dazu die folgenden Schritte.
I. Einbringen eines zu beschichtenden Substrates 30 und mindestens einer gasförmigen Vorläuferverbindung 20 in ein Reaktionsgefäß 10, sodass eine Atmosphäre mit mindestens einer Vorläuferverbindung (20) im Reaktionsgefäß (10) gebildet wird.

In einem ersten Schritt wird ein zu beschichtendes Substrat 30 mit mindestens einer gasförmigen Vorläuferverbindung 20 in ein Reaktionsgefäß 10 eingebracht. Das Einbringen der gasförmigen Vorläuferverbindung 20 erfolgt vorzugsverweise über eine regelbare Gaszuleitung 15.

Das Reaktionsgefäß 10 ist dabei eine Kammer geeigneter Form (z.B.: Zylinder oder Quader) und Größe (z.B. von 1 cm³ bis 10 m³) aus geeignetem Material (z.B.: Metall, Glas, Quarzglas). Das Reaktionsgefäß weist dabei entweder einen optischen Zugang (z.B.: Fenster, Faser) auf oder ist alternativ geeignet zur Aufnahme eines Lasers ausgebildet. Das Reaktionsgefäß ist dabei so ausgebildet, dass es ein Gasgemisch im Druckbereich zwischen 1 Pa bis 10⁶ Pa aufnehmen kann. Zum Einstellen des Drucks der Inert- und Trägergase kann das Reaktionsgefäß 10 eine Pumpe umfassen, über welche Inert- und Trägergase zu oder abgepumpt werden können.

Die wenigstens eine gasförmige Vorläuferverbindung 20, die Atome enthält, aus denen sich das gewünschte Beschichtung zusammensetzt, kann dabei Teil eines als Atmosphäre dienenden, molekularen Gasgemisches sein, das zusätzlich zu der wenigstens einen gasförmigen Vorläuferverbindung 20 Inert- und Trägergase (z.B. Argon, Stickstoff oder Wasserstoff) enthält. Beispiele für Vorläuferverbindungen sind: Kohlenwasserstoffe wie Methan, Silane, Germane, Ammoniak, Trimethylsilan oder Verbindungen enthaltend Sauerstoff und/oder Wasserstoff.

Substrate 30 können Werkstücke beliebiger Form (z.B.: planare Substrate, Fasern, Faserbündel, Freiformen) und beliebigen Materials (z.B.: Metalle wie Al, Ti; Halbleiter wie SiC; Isolatoren wie SiO₂) sein.

II. Erhitzen der in Schritt I gebildeten Atmosphäre über wenigstens einem Abschnitt der Oberfläche des Substrates (30) mittels eines Lasers (50), sodass aus Atmosphäre ein Plasma erzeugt und aufrechterhalten wird, wodurch die mindestens eine Vorläuferverbindung (20) aufgespalten wird, sodass sich einzelne Atome, Moleküle oder Ionen bilden und dadurch für die chemische Reaktion, aus der die Beschichtung resultiert, aktiviert werden. Über der Oberfläche meint hierbei einen Abstand von vorzugsweise weniger als 1cm.

Durch das Erzeugen und Aufrechterhalten des Plasmas über wenigstens einem Abschnitt der Oberfläche des Substrates 30, wird über diesem Abschnitt die mindestens eine Vorläuferverbindung 20 aufgespalten, sodass sich einzelne Atome, Moleküle oder Ionen bilden, die auf der Oberfläche oder in deren Nähe reagieren können. Dies gilt auch für sonst nicht reaktive Spezies (z.B. N₂), die im Plasma dann als reaktive Radikale vorliegen (z.B. reagieren Stickstoff-Radikale im gewünschten Temperaturfenster mit den Bor-Vorläuferverbindungen zu BN, während Bor-Vorläuferverbindungen in konventionellen Prozessen nicht mit molekularem N₂ zu BN reagieren). Optional wird gleichzeitig das Substrat 30 mittels des Lasers 50, eines weiteren Lasers oder durch ein anderes Verfahren (z.B. Induktionsheizen) erhitzt.

III. Reaktion der in Schritt II erzeugten Moleküle, Atome oder Ionen auf dem Substrat 30 oder in dessen Nähe und Erzeugung einer Beschichtung auf der Oberfläche des Substrates 30.

Anschließend reagieren die in Schritt II erzeugten Moleküle, Atome oder Ionen aus den Vorläuferverbindungen auf der Oberfläche oder in deren Nähe, so dass sich eine Beschichtung aus einem Teil der Reaktionsprodukte auf dem Substrat ausbildet.

Typische Beschichtungsdauern für die Schritte I bis III liegen im Bereich von 0,1 s bis zu 1 h, die Beschichtungsdauer korreliert mit der Schichtdicke. Je länger die Beschichtung dauert, desto größer ist die resultierende Schichtdicke. Die Wachstumsrate ist reaktionsabhängig. Typische Schichtdicken liegen im Bereich von 1 nm bis 100 µm.

Die Verfahrensschritte I bis III sind dabei kombinierbar mit konventionellem Heizen des Substrats und anderen Beschichtungstechniken.

Das Plasma wird dabei gezielt durch den Laser 50 lokal gezündet sowie aufrechterhalten und löst damit die chemische Reaktion aus. Diese Vorgehensweise verhindert räumlich ausgedehnte Übergangsbereiche. Außerdem wird der Reaktionsraum in einer kontrollierten Atmosphäre durch den Laser gezielt in Form, Position und Ausdehnung kontrolliert. Das zu beschichtende Substrat und der Laserfokus werden relativ zueinander im Beschichtungsprozess kontinuierlich oder schrittweise bewegt. Durch den Einsatz des räumlich kontrollierten Plasmas eröffnen sich neue Möglichkeiten, den Beschichtungsprozess lokal zu kontrollieren. Damit können kontrollierte partielle oder vollständige Beschichtungen auf planaren oder gekrümmten Oberflächen von Substraten unterschiedlicher Morphologie mit lokal variablen Schichteigenschaften durchgeführt werden. Das Plasma wird durch das elektrische Feld des Lasers erzeugt oder aufrechterhalten, daher muss das Substrat nicht kontaktiert werden. Durch die Variation der Laserintensität lassen sich unterschiedliche Plasmabedingungen einstellen (z.B.: unterschiedliche Konzentration der im Plasma enthaltenen Spezies) und so die lokalen Reaktionsbedingungen und die abgeschiedene Schicht gezielt beeinflussen (z.B. Dicke, Zusammensetzung oder Morphologie der Schicht). Der Einsatz von Beschichtungsverfahren auf Basis von lasergestützten Plasmen auch in Kombination mit lasergestütztem Heizen ist in einem großen (Partial-)druckbereich zwischen 1 Pa bis 10⁶ Pa möglich.

### Vorrichtung:

Eine Vorrichtung 100 zur Durchführung des erfindungsgemäßen Verfahrens zur chemischen Gasphasenabscheidung aufweisend wenigstens ein evakuierbares Reaktionsgefäß 10 zur Aufnahme eines Substrates 30 und wenigstens einer Vorläuferverbindung 20 und wenigstens einen Laser 50, welcher so angeordnet ist, dass er nahe der Oberfläche, d.h. im Abstand von -1 cm bis 1 cm von der Oberfläche des Substrats 30, fokussiert werden kann. Dabei kann auch die Form des Laserfokus, also seine dreidimensionale Feldverteilung, kontrolliert werden.

Das Reaktionsgefäß 10 besteht dabei beispielsweise aus Aluminium, Edelstahl, Keramik und/oder Glas und ist dabei evakuierbar ausgebildet.

Vorzugsweise weist es noch eine steuerbare Gaszuführung 15 zum kontrollierten Einbringen der wenigstens einen Vorläuferverbindung 20 auf.

Der Laser 50 ist dabei so ausgebildet, dass er monochromatisches oder polychromatisches Licht im Wellenlängenbereich von 100 nm bis 30 µm aussenden kann. Weiterhin ist er so ausgebildet, dass er dieses Licht gepulst oder kontinuierlich aussenden kann. Die Lichtleistung des verwendeten Lasers beträgt vorzugsweise mehr als 1 mW Dauerstrichäquivalent, umso eine zuverlässige Zündung und Aufrechterhaltung des Plasmas zu gewährleisten.

Vorzugsweise umfasst die Vorrichtung weiterhin ein erstes Regelelement zur relativen Positionierung von Substrat und Laserfokus, wie z.B. eine höhenverstellbare Arretierung 45 und/oder eine bewegliche Optik 40, und ein zweites Regelelement zur gezielten Variation von Laserleistung, Pulsrate oder Pulsdauer.

Vorzugsweise umfasst die Vorrichtung weiterhin eine Pumpe 60 in Kombination mit einer Gaszuführung 15, mit der die Atmosphäre in der Kammer kontrolliert werden kann.

### Ausführungsbeispiel

Eine konkrete Beschichtung von einem Substrat 30 aus SiC mit Kohlenstoff aus einer CH₂Cl₂ Vorläuferverbindung 20 mit N₂ als Trägergas läuft dabei folgendermaßen ab:
Das Substrat 30 wird in ein rohrförmige Reaktionsgefäß 10 gebracht, welche auf einer höhenverstellbaren Arretierung 45 liegt. Über eine Gaszuführung 15 wird ein Gasgemisch aus Inertgas und Vorläuferverbindung 20 in das Reaktionsgefäß 10 gebracht. Das Gasgemisch bildet die Atmosphäre im Reaktionsgefäß 10. Der Druck wird über eine Pumpe 60 geregelt. Ein Laser 50 wird durch eine bewegliche Optik 40 über dem Substrat fokussiert. Das Plasma wird am Fokuspunkt erzeugt und aufrechterhalten und die chemische Reaktion in Oberflächennähe, die zur Deposition des gewünschten Materials unterhalb des lokal gezündeten Plasmas führt, ausgelöst. Die relative Position von Substrat und Plasma kann über die Optik 40 und die Arretierung 45 eingestellt werden und damit die Position und Laserform auf der Werkstückoberfläche, an der beschichtet wird, variiert werden.

### Abbildungslegenden und Bezugszeichenliste

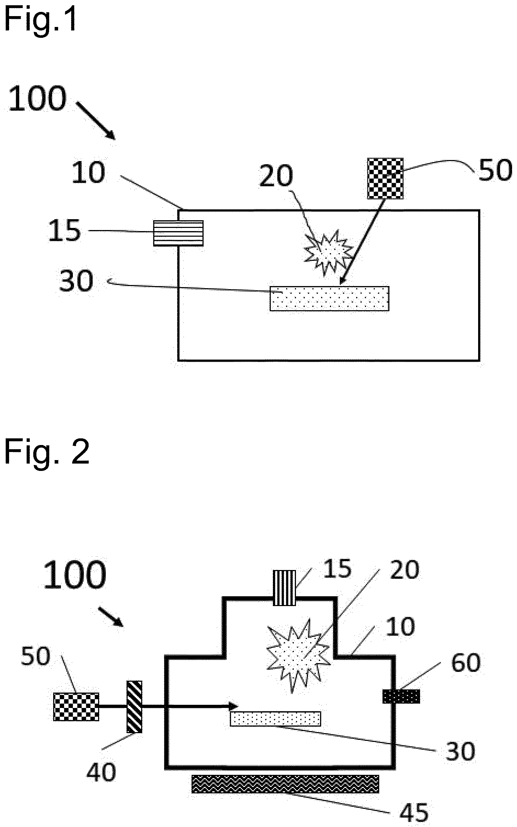

Fig. 1 zeigt eine beispielhafte Ausführungsform der erfindungsgemäßen Vorrichtung zur chemischen Gasphasenabscheidung.
Fig.2 zeigt die im Ausführungsbeispiel beschriebene konkrete Ausgestaltungsvariante der Vorrichtung 100

### Bezugszeichen

10 Reaktionsgefäß
15 Gaszuführung
20 gasförmig Vorläuferverbindung in einer Atmosphäre mit Trägergas
30 Substrat
40 Bewegliche Optik zur Manipulation des Laserfokus
45 Höhenverstellbare Arretierung
50 Laser
60 Pumpe
100 Vorrichtung zur Durchführung eines Verfahrens zur chemischen Gasphasenabscheidung

## Patentansprüche

1. Verfahren zur chemischen Gasphasenabscheidung umfassend wenigstens die folgenden Schritte
I. Einbringen eines zu beschichtenden Substrates (30) und mindestens einer gasförmigen Vorläuferverbindung (20) in ein Reaktionsgefäß (10), sodass eine Atmosphäre mit mindestens einer Vorläuferverbindung (20) im Reaktionsgefäß (10) gebildet wird.
II. Erhitzen der in Schritt I gebildeten Atmosphäre über wenigstens einem Abschnitt der Oberfläche des Substrates (30) mittels eines Lasers (50), sodass aus Atmosphäre ein Plasma erzeugt und aufrechterhalten wird, wodurch die mindestens eine Vorläuferverbindung (20) aufgespalten wird, sodass sich einzelne Atome, Moleküle oder Ionen bilden und dadurch für die chemische Reaktion, aus der die Beschichtung resultiert, aktiviert werden.
III. Reaktion der in Schritt II erzeugten Moleküle, Atome oder Ionen mit dem zu beschichtenden Substrat (30) oder in dessen Nähe und Erzeugung einer Beschichtung auf der Oberfläche des Substrates (30).

2. Verfahren zur chemischen Gasphasenabscheidung gemäß Anspruch 1, **dadurch gekennzeichnet, dass** in Schritt I weiterhin ein Inert- oder ein Trägergas in das Reaktionsgefäß eingebracht wird.

3. Verfahren zur chemischen Gasphasenabscheidung gemäß Anspruch 1 oder 2, **dadurch gekennzeichnet, dass** in Schritt II zusätzlich wenigstens ein Abschnitt der Oberfläche des zu beschichtenden Substrates (30) erhitzt wird.

4. Vorrichtung 100 zur Durchführung eines Verfahrens zur chemischen Gasphasenabscheidung gemäß einem der vorigen Ansprüche aufweisend ein evakuierbares Reaktionsgefäß (10) zur Aufnahme eines Substrates (30) und wenigstens einer Vorläuferverbindung (20) und wenigstens einen Laser (50), welcher so angeordnet ist, dass er nahe der Oberfläche des zu beschichtenden Substrats 30 fokussiert werden kann.

5. Vorrichtung (100) gemäß Anspruch 3, wobei diese eine steuerbare Gaszuführung (15) zum gesteuerten Einbringen der wenigstens einen Vorläuferverbindung (20) in das Reaktionsgefäß (10) aufweist.
